# EUROPÄISCHE PATENTSCHRIFT

(11) **EP 3 273 490 B1**
(45) Veröffentlichungstag und Bekanntmachung des Hinweises auf die Patenterteilung: **09.09.2020**
(21) Anmeldenummer: 17000912.0
(22) Anmeldetag: 30.05.2017
(51) Int. Cl.: H01L 31/049, B32B 27/32

(54) **MEHRSCHICHTIGE RÜCKSEITENFOLIE FÜR SOLARMODULE, SOLARMODUL SOWIE VERFAHREN ZUR HERSTELLUNG DER FOLIE UND DES MODULS**
MULTILAYER BACK SHEET FOR SOLAR MODULES, SOLAR MODULE AND METHOD FOR PRODUCING THE FILM AND THE MODULE
FILM DE PAROI ARRIÈRE EN COUCHES POUR PANNEAU SOLAIRE, PANNEAU SOLAIRE ET PROCÉDÉ DE FABRICATION DE FILM ET DU PANNEAU

(30) Priorität: 23.07.2016 DE 102016009020
(43) Veröffentlichungstag der Anmeldung: 24.01.2018
(73) Patentinhaber: Aluminium Féron GmbH & Co. KG, 52355 Düren (DE)
(72) Erfinder: Féron, Berthold, 52372 Kreuzau Bergheim (DE); Brandenburg, Marc, 52385 Nideggen (DE)
(74) Vertreter: Hauck Patentanwaltspartnerschaft mbB

(56) Entgegenhaltungen:
- EP-B1- 2 390 093
- US-A1- 2006 115 615
- US-A1- 2013 056 066

## Beschreibung

Die vorliegende Erfindung betrifft ein Solarmodul-Backsheet.

Mehrschichtige Rückseitenfolien (Backsheets) für Solarmodule sind bekannt. Generell besitzen derartige Solarmodule in der Reihenfolge von der Lichtempfangsseite bis zur Rückseite eine Deckschicht, eine obere Einbettungsschicht für Solarzellen, eine Solarzellenschicht, eine untere Einbettungsschicht für Solarzellen und ein sogenanntes Backsheet, das der hier in Rede stehenden Rückseitenfolie entspricht. Anstelle von getrennten Einbettungsschichten kann auch nur eine einzige Einbettungsschicht vorhanden sein, die die Solarzellenschicht aufnimmt.

Bei der Deckschicht handelt es sich üblicherweise um eine Glasschicht. Die Einbettungsschichten dienen zur Verkapselung und zum Schutz der Solarzellen und zur Fixierung derselben an der Deckschicht.

Das Backsheet, das die mehrschichtige Rückseitenfolie betrifft, sorgt für eine elektrische Isolierung des Solarmoduls und schützt den Solarmodul gegenüber Umgebungseinflüssen, insbesondere gegenüber Feuchtigkeit. Solche Backsheets enthalten typischerweise mehrere Schichten aus unterschiedlichen Materialien, wobei jedes Material einem anderen Zweck dient. Bekannt ist es beispielsweise, hierfür Fluorpolymere einzusetzen. Auch finden Polyethylenterephthalat (PET) -Polymere oder Polyethylennaphthalat (PEN) -Polymere Verwendung. Es versteht sich, dass bei diesen verschiedenen Materialien für eine ausreichende Haftung zwischen den einzelnen Schichten gesorgt werden muss. Ferner muss für die Haftung des gesamten Backsheets an der entsprechenden Einbettungsschicht des Solarmoduls Sorge getragen werden.

Um diese Probleme zu vermeiden, hat man gemäß der EP 2 390 093 B1 eine mehrschichtige Rückseitenfolie für Solarmodule konzipiert, bei der Deckschicht, Isolierschicht und Rückschicht jeweils als Hauptkomponente ein Polyolefin enthalten. Als vorteilhaft wird hierbei angesehen, dass bei einer derartigen Rückseitenfolie die vorstehend aufgezeigten Haftprobleme in den Hintergrund treten, weil alle Schichten als Hauptkomponente das ein- und dasselbe Basismaterial enthalten. Bei dieser Rückseitenfolie kann ferner als optionale Außenschicht eine Polyurethanschicht Verwendung finden. Bei Anordnung einer derartigen zusätzlichen Schicht sind entsprechende Zusatzmaßnahmen durchzuführen, um die gewünschte Haftung zwischen der Rückschicht aus Polyolefin und der zusätzlichen Polyurethanschicht zu erhalten.

Ferner ist eine Rückseitenfolie für Solarmodule aus der US 2013/0056066 A1 bekannt. Die Folie besitzt einen ersten Film aus einer Schicht aus Polyethylen niedriger Dichte, einer Zwischenschicht und einer weiteren Schicht aus Polyethylen niedriger Dichte sowie einen auf den ersten Film laminierten zweiten Film aus Polyester, PEN, PET, PVDF, PVF, ETFE etc. Beide Filme sind über einen Urethankleber miteinander verbunden.

Die vorliegende Erfindung bezweckt eine Weiterbildung eines derartigen Solarmodul-Backsheets. Ihr liegt die Aufgabe zugrunde, ein Solarmodul-Backsheet zur Verfügung zu stellen, das sich durch eine besonders gute Witterungs- und Temperaturbeständigkeit auszeichnet.

Diese Aufgabe wird erfindungsgemäß gelöst durch ein Solarmodul-Backsheet gemäß Patentanspruch 1.

Polyurethan zeichnet sich durch eine besonders gute Witterungsstabilität bzw. Temperaturstabilität aus, wobei die Zersetzungstemperatur von Polyurethan beträchtlich höher ist als die von üblichen Polyolefinen. Überraschenderweise wurde nunmehr festgestellt, dass eine solche Rückschicht aus Polyurethan konzipiert werden kann, ohne dass hierdurch die Effizienz in Bezug auf die Herstellung der Rückseitenfolie in wesentlichem Umfang beeinflusst wird. Mit anderen Worten, die Rückschicht aus Polyurethan lässt sich mit der Isolierschicht aus dem Polyolefin kombinieren, ohne dass hierdurch Haftungsprobleme entstehen oder besonders aufwändige Maßnahmen getroffen werden müssen, um für eine ausreichende Haftung zu sorgen.

Die erfindungsgemäß vorgesehene Rückschicht aus Polyurethan bietet daher einen besonders guten Schutz gegen Witterungseinflüsse, insbesondere Feuchtigkeit und erhöhte Temperatur.

Des Weiteren weist eine derartige Rückschicht aus einem Material auf Polyurethanbasis als Polymer-Hauptkomponente gute Anschlusseigenschaften auf. So lassen sich Anschlussdosen, Backrails etc. gut anbringen, insbesondere gut ankleben, beispielsweise mithilfe von Siliconklebern.

Der hier verwendete Begriff "Deckschicht" der Rückseitenfolie betrifft die Schicht, die mit der Rückseite des Solarmoduls verbunden wird, während die Rückschicht dann die entsprechende Außenseite bildet. In der Regel entspricht daher die Deckschicht der Oberseite und die Rückschicht der Unterseite der Rückseitenfolie.

Besonders gute Eigenschaften ergeben sich bei einer Ausführungsform, bei der die Rückschicht einen oder mehrere Füllstoffe enthält. Als Füllstoff kommt insbesondere Titandioxid in Frage. Es hat sich hierbei gezeigt, dass sich Polyurethan besonders gut in Bezug auf die Einarbeitung von Füllstoffen eignet. Auch die Deckschicht und/oder Isolierschicht können mit derartigen Füllstoffen versehen sein.

Was die Verbindung der Rückschicht mit der Isolierschicht anbetrifft, so sieht die Erfindung mehrere Verfahrensmöglichkeiten vor. Bei einer ersten Ausführungsform ist die Rückschicht als Folie mit dem restlichen Teil der Rückseitenfolie verklebt. Ein derartiger Klebevorgang kann beispielsweise mit einer Primerschicht erfolgen, die zwischen Rückschicht und dem restlichen Teil der Rückseitenfolie angeordnet ist.

Auch kann die Rückschicht auf den restlichen Teil der Rückseitenfolie als Lack aufgebracht sein. Eine derartige Lackschicht kann beispielsweise auf die darunter angeordnete Schicht (Isolierschicht) gestrichen oder aufgesprüht werden.

Generell können sämtliche Schichten als Folien miteinander verklebt sein. Auch die Deckschicht kann als Folie mit dem restlichen Teil der Rückseitenfolie verklebt oder als Lack auf den restlichen Teil aufgebracht sein.

Bei einer anderen Ausführungsform kommt eine Rückschicht zur Anwendung, die einer Vorbehandlung, insbesondere zur Haftungsverbesserung, unterzogen worden ist, beispielsweise einer Corona- oder Plasmabehandlung oder Ätzung. Generell können alle Schichten der Rückseitenfolie einer Vorbehandlung unterzogen werden.

Noch eine andere Ausführungsform zeichnet sich dadurch aus, dass die Rückschicht neben der Polymer-Hauptkomponente Polyurethan ein Polyolefin enthält, um auf diese Weise das Haftungsvermögen zur benachbarten Isolierschicht aus dem Polyolefin weiter zu verbessern.

Auch ist es möglich, die Rückschicht mit weiteren Schichten der Rückseitenfolie zu coextrudieren, um einen festen Verbund zu erhalten.

Auch betrifft die Erfindung eine Ausführungsform, bei der die Deckschicht, Isolierschicht und/oder die Rückschicht ein oder mehrere Additive enthalten.

Derartige Additive können beispielsweise zugesetzt werden, um das Haftungsvermögen zu verbessern. Solche Additive auf chemischer oder physikalischer Basis können natürlich auch andere Funktionen erfüllen.

Auf ihrer Oberseite, d. h. der zum Einbettungsmaterial des Solarmoduls benachbarten Seite, kann die mehrschichtige Rückseitenfolie eine Deckschicht aufweisen. Diese muss jedoch nicht zwingend vorhanden sein. Wenn eine derartige Deckschicht vorgesehen ist, wird vorgeschlagen, dass diese vorzugsweise als Polymer-Hauptkomponente Polyurethan oder ein Polyolefin umfasst. Bei Polyurethan ist auch hier der Vorteil einer hohen UV-Beständigkeit gegeben. Bei einem Polyolefin hat man den Vorteil, dass die Deckschicht dann aus dem gleichen Material wie die Isolierschicht besteht.

Um eine gute Haftung zwischen Isolierschicht und Deckschicht sicherzustellen, kann zwischen beiden Schichten eine Primerschicht vorgesehen sein.

Die mittlere Isolierschicht enthält zwingend als Polymer-Hauptkomponente ein vernetztes Polyolefin. Hierfür können beispielsweise Polyethylen oder Polypropylen oder deren Copolymere Verwendung finden. Auch vernetzte Substanzen können verwendet werden.

Zwischen den drei Hauptschichten, nämlich der optionalen Deckschicht, der Isolierschicht und der Rückschicht, und/ oder auf der Deckschicht können eine oder mehrere Unterschichten angeordnet sein, insbesondere die erwähnten Primerschichten zur Verbesserung des Haftvermögens. So kann auf der Deckschicht, wenn eine solche vorhanden ist, oder der Isolierschicht oder einer optionalen Schicht zur Verbindung mit einer Einbettungsschicht der Solarzellen eine Zusatzschicht, insbesondere Haftschicht, vorgesehen sein.

Das vorstehend erwähnte Material auf Polyurethanbasis kann ein solches sein, das mit geblockten Reaktionpartnern hergestellt wurde. Bei dem Material auf Polyolefinbasis kann es sich um ein vernetztes Material handeln. Auch kann bei der Rückseitenfolie die Deckschicht oder Isolierschicht oder optionale Schicht mit einer Einbettungsschicht für Solarzellen versehen sein. Bei dieser Ausführungsform ist daher die Rückseitenfolie bereits mit einer Einbettungsschicht für Solarzellen versehen, so dass diese Schicht die am Solarmodul vorgesehene Einbettungsschicht ergänzen kann.

Das Material auf Polyurethanbasis, das mit geblockten Reaktionspartnern hergestellt wurde, kann beispielsweise so hergestellt sein, dass die geblockten Reaktionspartner, insbesondere Isocyanat und Polyol, erst durch das Laminieren entblockt und zum Polyurethan umgewandelt werden.

Bei noch einer anderen Ausführungsform besitzt die Rückseitenfolie eine Barriereschicht, insbesondere aus Metall, wobei speziell eine Aluminiumfolie als Barriereschicht eingesetzt werden kann. Diese Barriereschicht kann zwischen Deckschicht und Isolierschicht oder auf der Deckschicht angeordnet sein. Mit einer derartigen Barriereschicht soll die Rückseitenfolie insbesondere vor dem Eindringen von Wasser geschützt werden.

Das erfindungsgemäß ausgebildete Backsheet vereint die Vorteile einer Kernschicht (Isolierschicht) aus einem Olefin mit denen einer Rückschicht aus Polyurethan. Durch die Isolierschicht auf Polyolefinbasis werden insbesondere gute Isolationseigenschaften und eine gute Wirtschaftlichkeit erreicht. Polyolefine besitzen jedoch eine relativ geringe UV-Stabilität, die durch die erfindungsgemäß vorgesehene Schicht auf Polyurethanbasis wesentlich verbessert wird. Die UV-Stabilität von Polyurethan ist sehr hoch, so dass sich insgesamt eine hohe Lebensdauer der Rückseitenfolie ergibt.

Die Erfindung betrifft ferner ein Verfahren zur Herstellung eines Solarmodul-Backsheets der vorstehend beschriebenen Art. Hierbei werden bei einer Ausführungsform Materialien für die Isolierschicht und Rückschicht und ggf. für die optionalen weiteren Schichten bereitgestellt und coextrudiert sowie wahlweise vernetzt. Entsprechende Vernetzungsverfahren für die verwendeten Polyolefine, insbesondere des Polyethylens für die Isolierschicht, sind bekannt.

Bei einer anderen Ausführungsform werden Materialien für die Isolierschicht und Rückschicht und ggf. für die optionalen weiteren Schichten in Folienform bereitgestellt und miteinander verklebt.

Bei noch einer anderen Variante werden die Rückschicht und/oder die Deckschicht als Lack auf die Isolierschicht oder optionale Schicht aufgebracht. Bei einer weiteren Ausführungsform wird das Material der Rückschicht und/oder Deckschicht über ein Transferverfahren auf die Isolierschicht oder optionale Schicht aufgebracht. Der Lack wird vorzugsweise aufgestrichen oder aufgesprüht. Entsprechende Transferverfahren sind dem Fachmann bekannt.

Auch betrifft die Erfindung einen Solarmodul mit einer oder mehreren Solarzellen und mindestens einer Einbettungsschicht für diese. Erfindungsgemäß weist der Solarmodul eine in den Solarmodul integrierte Rückseitenfolie der vorstehend beschriebenen Art auf.

Schließlich umfasst die Erfindung auch ein Verfahren zur Herstellung eines Solarmoduls, wobei eine Rückseitenfolie der vorstehend beschriebenen Art zur Erzeugung eines Backsheet auf eine Einbettungsschicht des Solarmoduls auflaminiert wird. Wie erwähnt, kann hierbei eine bereits mit einer Einbettungsschicht versehene Rückseitenfolie auflaminiert werden.

## Patentansprüche

1. Solarmodul-Backsheet, das als mehrschichtige Rückseitenfolie ausgebildet ist, welche die folgenden Bestandteile in dieser Reihenfolge umfasst:
a. eine optionale Deckschicht, insbesondere umfassend Polyurethan oder ein Polyolefin als Polymer-Hauptkomponente,
b. eine Isolierschicht und
c. eine die Außenseite der Rückseitenfolie bildende Rückschicht, die in direktem Kontakt mit der Isolierschicht steht,
wobei die Isolierschicht ein vernetztes Material auf Polyolefinbasis als Polymer-Hauptkomponente und die Rückschicht ein Material auf Polyurethanbasis als Polymer-Hauptkomponente, insbesondere ein solches, das mit geblockten Reaktionspartnern hergestellt wurde, enthält.

2. Backsheet nach Anspruch 1, **dadurch gekennzeichnet, dass** die Deckschicht, Isolierschicht und/oder Rückschicht einen oder mehrere Füllstoffe, insbesondere Titandioxid, enthalten.

3. Backsheet nach einem der vorangehenden Ansprüche, **dadurch gekennzeichnet, dass** die Deckschicht, Isolierschicht und/oder Rückschicht einer Vorbehandlung unterzogen worden sind, insbesondere einer Corona- oder Plasmabehandlung oder Ätzung.

4. Backsheet nach einem der vorangehenden Ansprüche, **dadurch gekennzeichnet, dass** die Rückschicht neben der Polymer-Hauptkomponente Polyurethan ein Polyolefin enthält.

5. Backsheet nach einem der vorangehenden Ansprüche, **dadurch gekennzeichnet, dass** Deckschicht, Isolierschicht und/oder Rückschicht ein oder mehrere Additive enthalten.

6. Backsheet nach einem der vorangehenden Ansprüche, **dadurch gekennzeichnet, dass** die Isolierschicht Polyethylen oder Polypropylen oder deren Copolymere als Polymer-Hauptkomponente enthält.

7. Backsheet nach einem der vorangehenden Ansprüche, **dadurch gekennzeichnet, dass** auf der Deckschicht oder der Isolierschicht zur Verbindung mit einer Einbettungsschicht der Solarzellen eine Zusatzschicht, insbesondere Haftschicht, vorgesehen ist.

8. Backsheet nach einem der vorangehenden Ansprüche, **dadurch gekennzeichnet, dass** die Deckschicht oder Isolierschicht mit einer Einbettungsschicht für Solarzellen versehen ist.

9. Verfahren zur Herstellung eines Backsheets nach einem der Ansprüche 1 bis 8, **dadurch gekennzeichnet, dass** Materialien für die Isolierschicht und Rückschicht bereitgestellt und coextrudiert werden.

10. Verfahren zur Herstellung eines Backsheets nach einem der Ansprüche 1 bis 8, **dadurch gekennzeichnet, dass** Materialien für die Isolierschicht und Rückschicht in Folienform bereitgestellt und miteinander verklebt werden.

11. Verfahren zur Herstellung eines Backsheets nach einem der Ansprüche 1 bis 8, **dadurch gekennzeichnet, dass** die Rückschicht und/oder die Deckschicht als Lack auf die Isolierschicht aufgebracht werden.

12. Verfahren zur Herstellung eines Backsheets nach einem der Ansprüche 1 bis 8, **dadurch gekennzeichnet, dass** das Material der Rückschicht und/oder Deckschicht über ein Transferverfahren auf die Isolierschicht aufgebracht wird.

13. Solarmodul mit einer oder mehreren Solarzellen und mindestens einer Einbettungsschicht für diese, **dadurch gekennzeichnet, dass** er ein in den Solarmodul integriertes Backsheet nach einem der Ansprüche 1 bis 8 aufweist.

14. Verfahren zur Herstellung eines Solarmoduls, **dadurch gekennzeichnet, dass** ein Backsheet nach einem der Ansprüche 1 bis 8 auf eine Einbettungsschicht für die Solarzellen auflaminiert wird.

## Claims

1. A solar module backsheet formed as multilayer backsheet which comprises the following components in this order:
a. an optional cover layer, especially comprising polyurethane or a polyolefin as polymer main component,
b. an insulation layer and
c. a back layer forming the outside of the backsheet which is in direct contact with the insulation layer,
wherein the insulation layer contains a crosslinked material on the basis of polyolefin as polymer main component and the back layer contains a material on the basis of polyurethane as polymer main component, especially such a material which was produced with blocked reaction partners.

2. The backsheet according to claim 1, **characterized in that** the cover layer, insulation layer and/or back layer contain one or more fillers, especially titanium dioxide.

3. The backsheet according to one of the preceding claims, **characterized in that** the cover layer, insulation layer and/or back layer have been submitted to a pretreatment, especially a corona treatment or plasma treatment or etching.

4. The backsheet according to one of the preceding claims, **characterized in that** the back layer contains a polyolefin in addition to the polymer main component polyurethane.

5. The backsheet according to one of the preceding claims, **characterized in that** the cover layer, insulation layer and/or back layer contain one or more additives.

6. The backsheet according to one of the preceding claims, **characterized in that** the insulation layer contains polyethylene or polypropylene or their copolymers as polymer main component.

7. The backsheet according to one of the preceding claim, **characterized in that** an additional layer, especially bonding layer, is provided on the cover layer or the insulation layer for the connection with an embedding layer of the solar cells.

8. The backsheet according the one of the preceding claims, **characterized in that** the cover layer or the insulation layer is provided with an embedding layer for the solar cells.

9. A method for producing a backsheet according to one of the claims 1 to 8, **characterized in that** materials for the insulation layer and back layer are provided and coextruded.

10. The method for producing a backsheet according to one of the claims 1 to 8, **characterized in that** materials for the insulation layer and back layer are provided in sheet form and are bonded with one another.

11. The method for producing a backsheet according to one of the claims 1 to 8, **characterized in that** the back layer and/or the cover layer are applied to the insulation layer as lacquer.

12. The method for producing a backsheet according to one of the claims 1 to 8, **characterized in that** the material of the back layer and/or cover layer is applied to the insulation layer by means of a transfer method.

13. A solar module with one or more solar cells and at least one embedding layer for the same, **characterized in that** it includes a backsheet according to one of the claims 1 to 8 integrated into the solar module.

14. A method for producing a solar module, **characterized in that** a backsheet according to one of the claims 1 to 8 is laminated onto an embedding layer for the solar cells.

## Revendications

1. Feuille de base de module solaire, qui est réalisée en tant que feuille protectrice arrière à plusieurs couches, laquelle comprend les éléments suivants dans cet ordre :
a. une couche de recouvrement optionnelle, comprenant en particulier du polyuréthane ou une polyoléfine en tant que composant principal polymère,
b. une couche isolante et
c. une couche arrière, formant la face extérieure de la feuille protectrice arrière, qui est en contact direct avec la couche isolante,
dans laquelle la couche isolante contient un matériau réticulé à base de polyoléfine comme composant principal polymère et la couche arrière un matériau à base de polyuréthane comme composant principal polymère, en particulier un tel qui a été produit avec des partenaires réactionnels bloqués.

2. Feuille de base selon la revendication 1, **caractérisée en ce que** la couche de recouvrement, couche isolante et/ou couche arrière contiennent une ou plusieurs charges, en particulier du dioxyde de titane.

3. Feuille de base selon l'une quelconque des revendications précédentes, **caractérisée en ce que** la couche de recouvrement, couche isolante et/ou couche arrière sont soumises à un prétraitement, en particulier un traitement corona ou par plasma ou une gravure.

4. Feuille de base selon l'une quelconque des revendications précédentes, **caractérisée en ce que** la couche arrière contient en plus du composant principal polymère polyuréthane une polyoléfine.

5. Feuille de base selon l'une quelconque des revendications précédentes, **caractérisée en ce que** les couche de recouvrement, couche isolante et/ou couche arrière contiennent un ou plusieurs additifs.

6. Feuille de base selon l'une quelconque des revendications précédentes, **caractérisée en ce que** la couche isolante contient du polyéthylène ou polypropylène ou les copolymères de ceux-ci en tant que composant principal polymère.

7. Feuille de base selon l'une quelconque des revendications précédentes, **caractérisée en ce qu'**une couche additionnelle, en particulier couche adhésive, est prévue sur la couche de recouvrement ou la couche isolante aux fins de liaison à une couche d'encastrement des cellules solaires.

8. Feuille de base selon l'une quelconque des revendications précédentes, **caractérisée en ce que** la couche de recouvrement ou couche isolante est pourvue d'une couche d'encastrement pour des cellules solaires.

9. Procédé de production d'une feuille de base selon l'une quelconque des revendications 1 à 8, **caractérisé en ce que** des matériaux pour la couche isolante et couche arrière sont fournis et coextrudés.

10. Procédé de production d'une feuille de base selon l'une quelconque des revendications précédentes 1 à 8, **caractérisé en ce que** des matériaux pour la couche isolante et couche arrière sont fournis sous forme de feuille et collés les uns aux autres.

11. Procédé de production d'une feuille de base selon l'une quelconque des revendications 1 à 8, **caractérisé en ce que** la couche arrière et/ou la couche de recouvrement sont appliquées comme vernis sur la couche isolante.

12. Procédé de production d'une feuille de base selon l'une quelconque des revendications 1 à 8, **caractérisé en ce que** le matériau de la couche arrière et/ou couche isolante est appliqué sur la couche isolante par l'intermédiaire d'un procédé de transfert.

13. Module solaire avec une ou plusieurs cellules solaires et au moins une couche d'encastrement pour celles-ci, **caractérisé en ce qu'**il présente une feuille de base selon l'une quelconque des revendications 1 à 8 intégrée dans le module solaire.

14. Procédé de fabrication d'un module solaire, **caractérisé en ce qu'**une feuille de base selon l'une quelconque des revendications 1 à 8 est stratifiée sur une couche d'encastrement pour les cellules solaires.
